Europäisches Patentamt

European Patent Office

Office européen des brevets

(11) Veröffentlichungsnummer: **0 177 802**
**A2**

## (12) EUROPÄISCHE PATENTANMELDUNG

(21) Anmeldenummer: 85111615.2

(22) Anmeldetag: 13.09.85

(51) Int. Cl.⁴: **H 01 L 27/20**

(30) Priorität: 27.09.84 DE 3435570

(43) Veröffentlichungstag der Anmeldung: 16.04.86
Patentblatt 86/16

(84) Benannte Vertragsstaaten: DE FR GB NL

(71) Anmelder: **Siemens Aktiengesellschaft, Berlin und München Wittelsbacherplatz 2, D-8000 München 2 (DE)**

(72) Erfinder: **Gräbner, Günther, Am Herrengarten 3, D-8551 Heroldsbach (DE)**
Erfinder: **Lerch, Reinhard, Dr., Lachnerstrasse 57, D-8520 Erlangen (DE)**

(54) Ladungssensoranordnung.

(57) Ladungssensoranordnung mit mindestens einem Linearsensor (2), der mehrere nebeneinander auf einem gemeinsamen Siliziumsubstrat angeordnete Sensorelemente enthält, die jeweils mit einer Sensorfläche aus piezoelektrischem Material und einem Schalttransistor versehen ist. Erfindungsgemäß sind den Sensorelementen jeweils als Schalttransistor ein Dual-Gate-MOS-FET (6) zugeordnet, ist das Siliziumsubstrat mit einem Ladungsverschiebeelement (16) versehen, ist eine Elektrode (4) der Sensorfläche jeweils mit dem ersten Gate (8) des zugeordneten Dual-Gate-MOS-FET (6) verbunden, sind den Drainanschlüssen (14) jeweils eine MOS-Kapazität des Ladungsverschiebeelementes (16) zugeordnet und die zweiten Gates (10) sind mit einer Phasenumschaltleitung (12) und die Sourceanschlüsse (18) mit einer Stromspeiseleitung (20) verbunden. Durch diese Gestaltung erhält man eine Ladungssensoranordnung, deren beispielsweise infolge eines Druckes generiertes zweidimensionales Ladungsbild als serielle Signalfolge ausgelesen wird und deren Aufbau einfach und in Siliziumtechnologie integriert ist.

SIEMENS AKTIENGESELLSCHAFT      Unser Zeichen
Berlin und München              VPA **84 P 3 3 9 6 E**

Ladungssensoranordnung

Die Erfindung bezieht sich auf eine Ladungssensoranordnung mit mindestens einem Linearsensor, der mehrere nebeneinander auf einem gemeinsamen Siliziumsubstrat angeordnete Sensorelemente enthält, die jeweils mit einer Sensorfläche aus piezoelektrischem Material und einem Schalttransistor versehen sind.

Es sind Ladungsverschiebeelemente Charge Transfer Devices CTDs bekannt, die nach der Art der Signaleingabe in Bucket-Brigade-Devices BBDs, Charge-Coupled-Devices CCDs und Charge Injection Devices CIDs aufgeteilt sind. Bei der Analog-Signalverarbeitung benutzt man CTD-System in der Form von BBD- und CCD-Strukturen für Verzögerungsleitungen und Abtast-Analogfilter. Außerdem benutzt man CCD-Strukturen auch bei Linearsensoren und Bildsensoren. Bedingt durch die kleinere Integrationsdichte und größeren Rauschquellen werden für Linearsensoren und Bildsensoren keine BBD-Strukturen eingesetzt. Im digitalen Bereich können CCD-Speicher, die dynamische Speicher darstellen, rotierende Massenspeicher von Magnetbandgeräten bis zu Floppy-Disk-Systemen ersetzen, da die Probleme der mechanischen Systeme bei CCD-Speicher nicht auftreten und die Zugriffszeiten dieser CCD-Speicher gegenüber mechanischer Massenspeicher um eine Größenordnung kleiner ist. Die CIDs werden als Bildsensoren verwendet, die das Koinzidenzauswahlverfahren benutzen. Somit kann man den Nachteil der CCD-Sensoren, nämlich der Auswahl einer gesamten Bildzeile bei einem einzigen defekten CCD-Transfer-Element vermeiden. Bei den Bildsensoren

Ur 2 Hag / 20.9.1984

mit einer CCD- oder CID-Struktur werden die Ladungen optisch generiert ("Elektronik", 1979, Heft 12, Seiten 39 bis 47 und Heft 13, Seiten 74 bis 81).

Außerdem ist ein Linear- und ein zweidimensionales Ultraschallarray bekannt, das eine Polyvinyliden-Fluorid PVDF-Folie und ein Siliziumsubstrat enthält. Das Siliziumsubstrat enthält für jede Sensorzelle, die beispielsweise bei dem zweidimensionalen Ultraschallbild als Matrix angeordnet sind, einen Schalttransistor, der auch als Teil eines Multiplexers verwendet werden kann. Die der PVDF-Folie zugewandte Flachseite des Siliziumsubstrats ist mit einer Siliziumoxidschicht versehen, die mehrere Sensorzellenelektroden enthält. Diese Elektroden sind jeweils mit dem Gate eines zugeordneten Schalttransistors verbunden. Die PVDF-Folie ist großflächig auf die Silizium-Oxidschicht geklebt, und die einem Untersuchungsobjekt zugewandte Flachseite der PVDF-Folie ist mit einer gemeinsamen großflächigen Elektrode versehen. Das Feld der Ladung der PVDF-Folie steuert direkt das jeweilige Gate der Schalttransistoren. Ein zweidimensionales Ladungsbild wird beispielsweise spaltenweise ausgelesen (R.G.Swartz, J.D.Plummer, Acoustical Holography, Vol. III, 1979, June, Seiten 69 bis 95).

Der Erfindung liegt nun die Aufgabe zugrunde, eine Ladungssensoranordnung anzugeben, deren Ladung infolge beispielsweise eines Druckes oder beispielsweise einer Beschallung mit Ultraschallwellen generiert wird. Außerdem soll der Aufbau dieser Ladungssensoranordnung einfach und voll in Siliziumtechnologie integriert sein. Weiter soll die Ladungssensoranordnung mit möglichst wenigen Steuerleitungen angesteuert und ein zweidimensionales Ladungsbild über einen Signalausgang ausgelesen werden.

Diese Aufgabe wird erfindungsgemäß gelöst mit den kennzeichnenden Merkmalen des Anspruchs 1. Jedem Sensorelement ist ein Dual-Gate-MOS-FET zugeordnet, der jeweils vorzugsweise im geometrischen Schatten des entsprechenden Sensorelementes angeordnet ist. Im geometrischen Schatten dieser Dual-Gate-MOS-FETs ist ein Ladungsverschiebeelement, beispielsweise ein BBD, angeordnet. In Abhängigkeit der Ladung, die auf den Sensorflächen generiert ist, wird jeweils das erste Gate der Dual-Gate-MOS-FETs gesteuert und somit in der Einlesephase der Speisestrom, der jeweils über die Source-Drain-Strecke der Dual-Gate-MOS-Fets in die entsprechenden MOS-Kapazitäten des BBDs fließt. Damit der Speisestrom während der Einlesephase fließen kann, wird jeweils das zweite Gate der Dual-Gate-MOS-FETs mit Hilfe eines Taktimpulses, das über eine Phasenumschaltleitung gelangt, leitend geschaltet. In der Auslesephase ist das zweite Gate sperrend geschaltet und die Ladungen in den MOS-Kapazitäten des BBDs werden mit Hilfe von Steuerimpulsen zum Ausgang transportiert. Somit erhält man einen Ladungssensor, dessen Ladung mit Hilfe weniger Steuerleitung seriell zum Ausgang transportiert wird. Außerdem ist der Aufbau dieser Ladungssensoranordnung in voll integrierter Siliziumtechnologie vorteilhaft.

In einer vorteilhaften Ausführungsform der Ladungssensoranordnung sind mehrere Linearsensoren nebeneinander auf einem gemeinsamen Siliziumsubstrat integriert und den Ladungsverschiebeelementen der Linearsensoren ist ein zusätzliches Ladungsverschiebeelement, beispielsweise ein BBD, zugeordnet. Dieses Ladungsverschiebeelement ist senkrecht zu den Ladungsverschiebeelementen der Linearsensoren angeordnet. Außerdem sind die Stromspeiseleitungen und die Phasenumschaltleitungen der Linearsensoren elektrisch parallel geschaltet. Dadurch wird erreicht, daß ein zweidimensionales Ladungsbild, das auf den Sensorflächen der Ladungssensoranordnung mit Hilfe beispielsweise eines Druckes oder beispielsweise einer Beschallung mit Ultraschallwellen generiert ist, während der Einlesephase den Speisestrom über die Dual-Gate-MOS-Fets in die MOS-Kapazitäten der Ladungsverschiebeelemente der Linearsensoren steuert. Während der Auslesephase werden die in den MOS-Kapazitäten gespeicherten Ladungen jeweils zum Ausgang der Ladungsverschiebeelemente der Linearsensoren transportiert und mit Hilfe des senkrecht zu diesen Ladungsverschiebeelementen angeordnetes zusätzliches Ladungsverschiebeelement seriell am Ausgang der Ladungssensoranordnung ausgelesen. Somit erhält man eine zweidimensionale Ladungssensoranordnung, deren zweidimensionales Ladungsbild mit Hilfe weniger Steuerleitungen seriell über einen Ausgang ausgelesen werden kann. Durch die Integration in Siliziumtechnologie erhält man einen verhältnismäßig einfach aufgebauten und kompakten Bildsensor.

In einer besonders vorteilhaften Ausführungsform der Ladungssensoranordnung sind mehrere Matrixsensoren als Matrixelemente einer nxm- oder nxn-Matrix auf einem gemeinsamen Trägersubstrat angeordnet. Die Ladungsverschiebeelemente der Matrixsensoren sind spalten- oder zeilenweise in Reihe geschaltet. Außerdem sind die Stromspeiseleitungen und die Phasenumschaltleitungen der Matrixsensoren elektrisch parallel geschaltet. Somit erhält man eine beliebig gestaltete Ladungssensoranordnung, deren zweidimensionales Ladungsbild unabhängig seiner räumlichen Ausdehnung, der Anzahl der Sensorelemente und der Auflösung mit Hilfe weniger Steuerleitungen seriell über wenige Ausgänge ausgelesen werden kann.

Zur weiteren Erläuterung wird auf die Zeichnung Bezug genommen in der ein Ausführungsbeispiel einer Ladungssensoranordnung nach der Erfindung schematisch veranschaulicht ist.

Figur 1 zeigt eine Ladungssensoranordnung gemäß der Erfindung, die als Linearsensor ausgebildet ist und in

Figur 2 ist eine Ladungssensoranordnung veranschaulicht, die als Matrix aufgebaut ist.

Figur 3 stellt eine Ladungssensoranordnung dar bei dem Matrixsensoren als Matrixelemente in Zeilen und Spalten angeordnet sind.

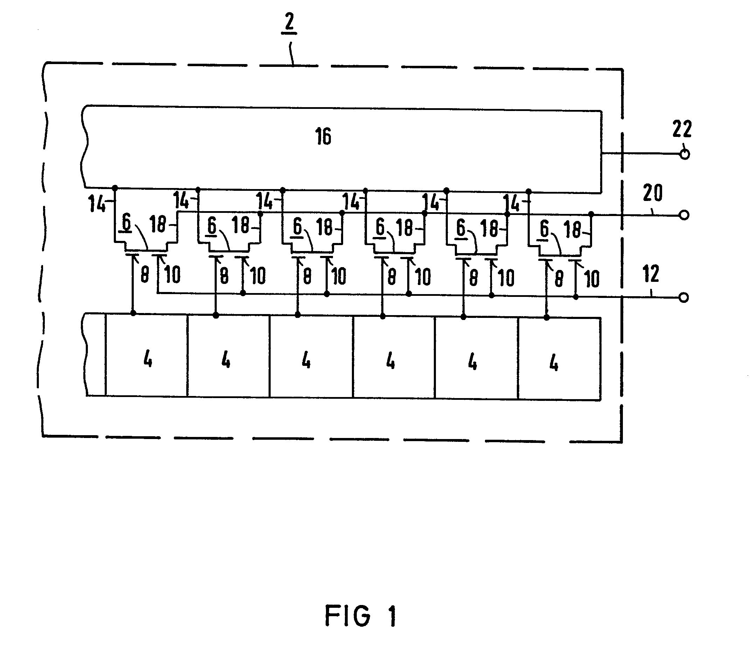

In der Ausführungsform nach Figur 1 ist eine Ladungssensoranordnung dargestellt, die als ein Linearsensor 2 ausgebildet ist. Dieser Linearsensor 2 enthält mehrere nebeneinander auf einem Siliziumsubstrat angeordnete Sensorelemente, von denen in der Figur jeweils nur eine Elektrode 4 dargestellt ist. Die Sensorelemente enthalten jeweils zwischen zwei Elektroden eine piezoelektrische Schicht, beispielsweise Blei-Zirkonat-Titanat PZT, vorzugsweise Barium-Titanat, insbesondere Polyvinylidenfluorid PVDF, wobei die Elektroden, die dem Siliziumsubstrat abgewandt sind als großflächige Elektrode gestaltet ist und mit einer elektrischen Masse verbunden ist. Den Sensorelementen sind jeweils als Schalttransistor ein Dual-Gate-MOS-Fet 6 zugeordnet. Jeweils das erste Gate 8 dieser Dual-Gate-MOS-Fets 6 ist mit einer Elektrode 4 der Sensorelemente verbunden. Die zweiten Gates 10 sind mit einer Phasenumschaltleitung 12 verbunden. Die Drainanschlüsse 14 der Dual-Gate-MOS-FETs 6 sind jeweils mit MOS-Kapazitäten eines Ladungsverschiebeelementes 16 der Linearsensoren 2, vorzugsweise einem Bucket-Brigade-Device
BBD, und die Sourceanschlüsse 18 der Dual-Gate-MOS-FETs
6 sind mit einer Stromspeiseleitung 20 versehen. Die
Dual-Gate-MOS-FETs 6 und das Ladungsverschiebeelement
16 sind voll im Siliziumsubstrat integriert. Die
Sensorelemente sind auf dem Siliziumsubstrat derart
angeordnet, daß die Einzelelektroden der dotierten
Oberfläche des Siliziumsubstrats zugewandt sind, und
die Dual-Gate-MOS-FETs 6 sind im geometrischen Schatten
der Sensorelemente angeordnet.

In der Einlesephase werden mit Hilfe eines Impulses,
der über die Phasenumschaltleitung 12 gleichzeitig an
die zweiten Gates 10 der Dual-Gate-MOS-FETs 6 gelangt,
diese zweiten Gates 10 leitend geschaltet. Während
dieser Zeit fließt ein Strom über die Stromspeiseleitung 20 und der Source-Drain-Strecke der Dual-Gate-
MOS-FETs 6 in entsprechende MOS-Kapazitäten des Ladungsverschiebeelementes 16 des Linearsensors 2, deren
erste Gates 8 leitend geschaltet sind. In Abhängigkeit
einer Ladung die infolge beispielsweise eines Druckes
oder beispielsweise einer Beschallung mit Ultraschallwellen auf den Elektroden 4 der Sensorelemente generiert ist, wird jeweils das erste Gate 8 der entsprechenden Dual-Gate-MOS-FETs 6 gesteuert. Somit wird der
Stromfluß durch die Source-Drain-Strecke dieser Dual-
Gate-MOS-FETs 6 in die MOS-Kapazitäten des Ladungsverschiebeelementes 16 des Linearsensors 2 in Abhängigkeit der generierten Ladung gesteuert. In der
Auslesephase wird mit Hilfe eines Impulses, der über
die Phasenumschaltleitung 12 gleichzeitig an die zweiten Gates 10 gelangt, diese zweiten Gates sperrend
schalten. Außerdem werden die in einen Teil der MOS-
Kapazitäten des Ladungsverschiebeelementes 16 des Linearsensors 2 gespeicherten Ladungen zu einem Ausgang
22 dieses Ladungsverschiebeelementes 16 transportiert
und seriell ausgelesen.

Durch diese Gestaltung erhält man eine einfach aufgebaute voll integrierte Ladungssensoranordnung in
Siliziumtechnologie, die einfach gesteuert und deren
Ladungsbild seriell ausgelesen werden kann.

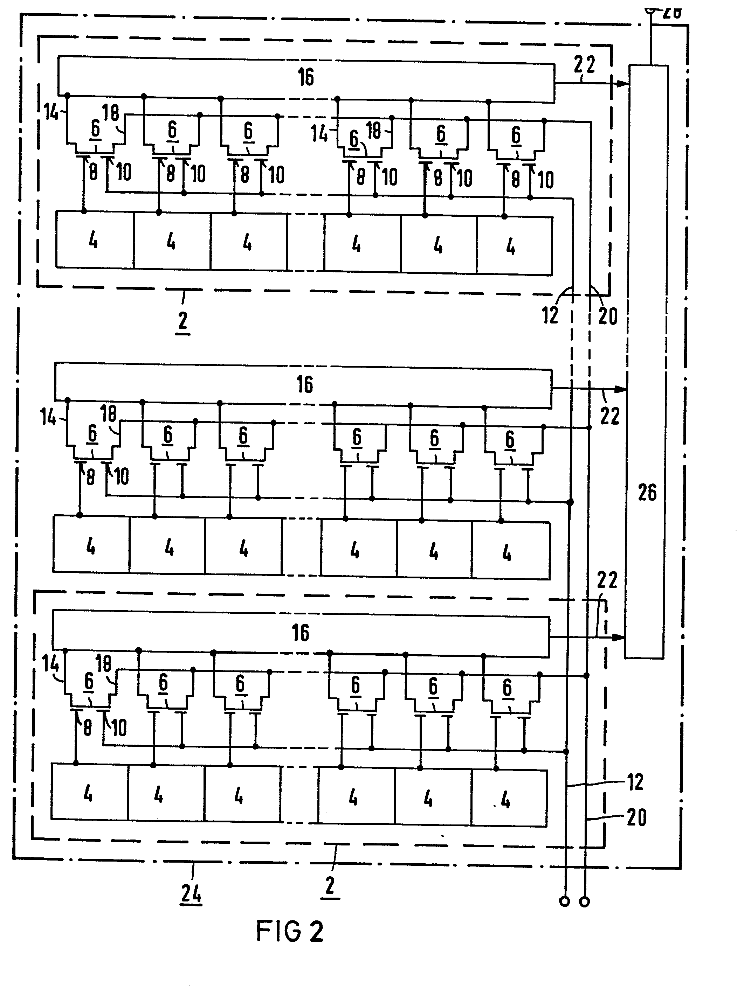

In Figur 2 ist eine vorteilhafte Ausführungsform der
Ladungssensoranordnung dargestellt. In dieser Ausführungsform sind mehrere Linearsensoren 2 nebeneinander
auf einem gemeinsamen Siliziumsubstrat angeordnet und
bilden einen Matrixsensor 24. Die Linearsensoren 2 sind
beispielsweise als Spalten des Matrixsensors 24 angeordnet. Den Ladungsverschiebeelementen 16 der Linearsensoren 2 ist ein zusätzliches Ladungsverschiebeelement 26, beispielsweise ein BBD, zugeordnet, das
senkrecht zu den Ladungsverschiebeelementen 16 der
Linearsensoren 2 angeordnet ist. Die Phasenumschaltleitungen 12 und die Stromspeiseleitungen 20 der
Linearsensoren 2 sind elektrisch parallelgeschaltet.

In der Einlesephase fließt ein Strom in Abhängigkeit
eines auf den Elektroden 4 der Sensorelemente
generiertes zweidimensionales Ladungsbildes über die
Stromspeiseleitungen 20 und den Source-Drain-Strecken
der Dual-Gate-MOS-FETs 6 der Linearsensoren 2 in entsprechende MOS-Kapazitäten der Ladungsverschiebungselementen 16. In der Auslesephase werden die zweiten
Gates 10 der Dual-Gate-MOS-FETs 6 mit Hilfe der Phasenumschaltleitungen 12 sperrend geschaltet und die in den
MOS-Kapazitäten der Ladungsverschiebeelementen 16 der
Linearsensoren 2 gespeicherte Ladungen jeweils zum
Ausgang 22 dieser Ladungsverschiebeelemente 16 transportiert, in das zusätzliche Ladungsverschiebeelement
26 geladen und zu seinem Ausgang 28 transportiert. Am
Ausgang 28 dieses Matrixsensors 24 erhält man das
zweidimensionale Ladungsbild als serielle Signalfolge.

Somit erhält man eine als Matrix gestaltete integrierte hochauflösende Ladungssensoranordnung, deren
zweidimensionales Ladungsbild mit Hilfe nur einiger,
beispielsweise 6, Steuerleitungen über einen Ausgang 28
seriell ausgelesen wird.

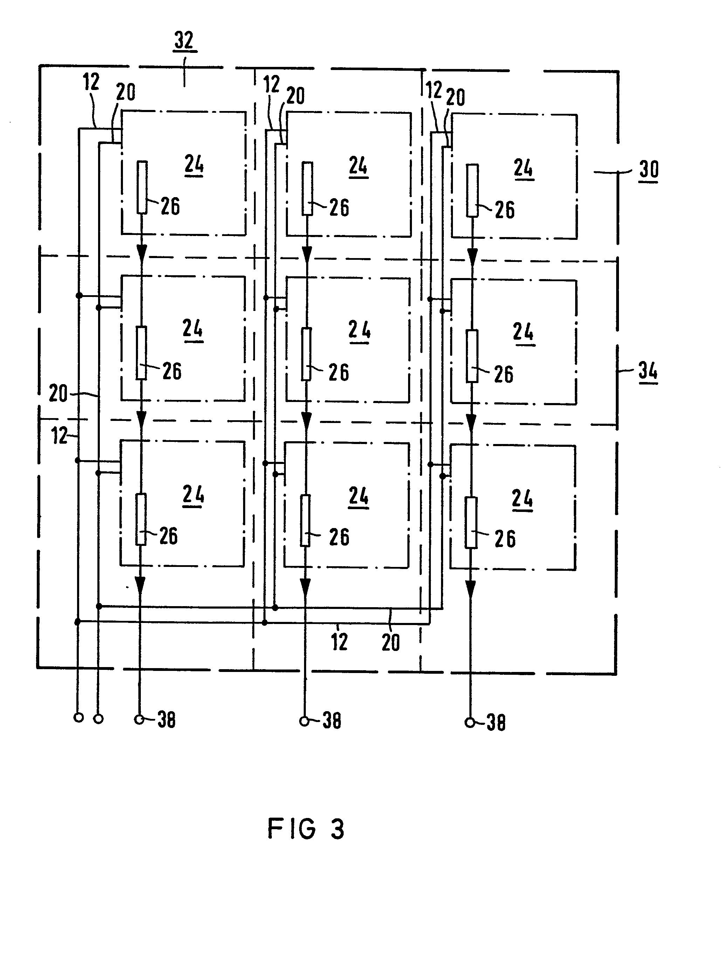

In Figur 3 ist eine besonders vorteilhafte Ausführungsform der Ladungssensoranordnung dargestellt. In
dieser Ausführungsform sind mehrere Matrixsensoren 24,
die beispielsweise als Matrixelemente in Zeilen 30 und
Spalten 32 einer nxn-Matrix auf einem gemeinsamen
Trägersubstrat angeordnet und bilden einen hochauflösenden Matrixsensor 34. Die zusätzlichen Ladungsverschiebeelemente 26 der in Spalten 32 angeordneten
Matrixsensoren 24 sind jeweils elektrisch in Reihe
geschaltet. Die Phasenumschaltleitungen 12 und die
Stromspeiseleitungen 20 der Matrixsensoren 24 sind
elektrisch parallelgeschaltet. Um die Funktionsfähigkeit dieses Ladungssensors zu garantieren, können
bekanntlich redundante Bauelemente, beispielsweise
Ladungsverschiebeelemente, vorgesehen sein. Durch diese
Gestaltung kann man eine beliebig gestaltete Ladungssensoranordnung unabhängig seiner räumlichen Ausdehnung, der Anzahl der Sensorflächen und der Auflösung
auf einen gemeinsamen Silizumsubstrat aufbauen und
deren zweidimensionales Ladungsbild mit Hilfe weniger,
beispielsweise etwa 6, Steuerleitungen parallel über
mehrere Ausgänge 38 auslesen. Durch die hohe Integration und den wenigen Leitungszuführungen ist diese
Ladungssensoranordnung vorzugsweise als Ultraschall-Bildaufnehmer, insbesondere als taktiler Sensor
für Handhabungsmaschinen oder Roboter geeignet.

10 Patentansprüche
3 Figuren

0177802

## Patentansprüche

1. Ladungssensoranordnung mit mindestens einem Linearsensor (2), der mehrere nebeneinander auf einem gemeinsamen Siliziumsubstrat angeordnete Sensorelemente enthält, die jeweils mit einer Sensorfläche aus piezoelektrischem Material und einem Schalttransistor versehen sind, d a d u r c h   g e k e n n-z e i c h n e t ,   daß den Sensorelementen jeweils als Schalttransistor ein Dual-Gate-MOS-FET (6) zugeordnet sind, daß das Siliziumsubstrat mit einem Ladungsverschiebeelement (16) versehen ist, daß eine Elektrode (4) der Sensorflächen jeweils mit dem ersten Gate (8) des zugeordneten Dual-Gate-MOS-FET (6) verbunden ist, daß das zweite Gate (10) der Dual-Gate-MOS-FETs (6) mit einer Phasenumschaltleitung (12) und der Sourceanschluß 18 mit  einer Stromspeiseleitung (20) verbunden sind, daß dem Drainanschluß (14) der Dual-Gate-MOS-FETs (6) jeweils eine MOS-Kapazität des Ladungsverschiebeelementes (16) zugeordnet ist und daß die Dual-Gate-MOS-FETs (6) und das Ladungsverschiebeelement (16) jeweils unterhalb der Elektrode (4) der Sensorelemente angeordnet sind.

2. Ladungssensoranordnung nach Anspruch 1,   d a-d u r c h   g e k e n n z e i c h n e t ,   daß als Ladungsverschiebeelemente (16, 26, 36) Bucket-Brigade-Devices BBDs vorgesehen sind.

3. Ladungssensoranordnung mit mehreren Linearsensoren (2) nach Anspruch 1, die auf einem gemeinsamen Siliziumsubstrat nebeneinander angeordnet sind.

4. Ladungssensoranordnung  nach Anspruch 3,   d a-d u r c h   g e k e n n z e i c h n e t ,   daß den

Ladungsverschiebeelementen (16) der Linearsensoren (2)
ein gemeinsames zusätzliches Ladungsverschiebeelement
(26) zugeordnet ist, das senkrecht zu den Ladungsverschiebeelementen (16) der Linearsensoren (2) angeordnet ist.

5. Ladungssensoranordnung nach Anspruch 3,   d a -
d u r c h   g e k e n n z e i c h n e t ,   daß die
Phasenumschaltleitungen (12) und die Stromspeiseleitungen (20) der Linearsensoren (2) jeweils elektrisch
parallelgeschaltet sind.

6. Ladungssensoranordnung mit mehreren Matrixsensoren
(24) nach Anspruch 3, die als Matrixelemente in Zeilen
(30) und Spalten (32) einer nxm-Matrix auf einem gemeinsamen Siliziumsubstrat angeordnet sind.

7. Ladungssensoranordnung nach Anspruch 6,   d a -
d u r c h   g e k e n n z e i c h n e t ,   daß die
Ladungsverschiebeelemente (26) der in Zeilen (30)
angeordneten Matrixsensoren (24) elektrisch in Reihe
geschaltet sind.

8. Ladungssensoranordnung nach Anspruch 6,   d a -
d u r c h   g e k e n n z e i c h n e t ,   daß die
Ladungsverschiebeelemente (26) der in Spalten (32)
angeordneten Matrixsensoren (24) elektrisch in Reihe
geschaltet sind.

9. Ladungssensoranordnung nach Anspruch 6,   d a -
d u r c h g e k e n n z e i c h n e t ,   daß die
Phasenumschaltleitungen (12) und die Stromspeiseleitungen (20) der Matrixsensoren (24) jeweils
elektrisch parallelgeschaltet sind.

0177802

10. Ladungssensoranordnung nach Anspruch 3 oder 6, dadurch gekennzeichnet, daß redundante Ladungsverschiebeelemente vorgesehen sind.

FIG 1

FIG 2

FIG 3